# FASCICULE DE BREVET EUROPEEN

(11) **EP 2 875 522 B1**
(45) Date de publication et mention de la délivrance du brevet: **08.01.2020**
(21) Numéro de dépôt: 13744763.7
(22) Date de dépôt: 17.07.2013
(51) Int. Cl.: H01L 21/308, B81C 1/00, B82Y 40/00

(54) **PROCÉDÉ DE FABRICATION D'UNE COUCHE MINCE DE NANORELIEFS DE SILICIUM ORDONNES**
VERFAHREN ZUR HERSTELLUNG EINER DÜNNSCHICHT AUF GEORDNETEN SILICIUMNANOMUSTERN
METHOD FOR MANUFACTURING A THIN FILM OF ORDERED SILICON NANOPATTERNS

(30) Priorité: 18.07.2012 FR 1256948
(43) Date de publication de la demande: 27.05.2015
(73) Titulaire: Université de Technologie de Troyes, 10010 Troyes Cedex (FR); Université Pierre et Marie Curie (Paris 6), 75252 Paris Cedex 05 (FR)
(72) Inventeur: LERONDEL, Gilles, F-10800 Saint Julien (FR); GROSSO, David, F-91630 Cheptainville (FR); BOISSIERE, Cédric, F-91140 Villebon Sur Yvette (FR)
(74) Mandataire: Gauchet, Fabien Roland
(86) Numéro de dépôt international: PCT/FR2013/051716
(87) Numéro de publication internationale: WO 2014/013193

(56) Documents cités:
- JOHNSTON D E ET AL: "Plasma etch transfer of self-assembled polymer patterns", PROCEEDINGS OF THE SPIE - THE INTERNATIONAL SOCIETY FOR OPTICAL ENGINEERING SPIE, vol. 8328, 29 mars 2012 (2012-03-29), XP008160753, THE INTERNATIONAL SOCIETY FOR OPTICAL ENGINEERING USA ISSN: 0277-786X
- FISHER A ET AL: "Surface Nanopatterning by Organic/Inorganic Self-Assembly and Selective Local Functionalization", SMALL, WILEY, vol. 2, no. 4, 1 janvier 2006 (2006-01-01) , pages 569-574, XP009086285, VCH VERLAG GMBH & CO. KGAA, DE ISSN: 1613-6810, DOI: 10.1002/SMLL.200500333
- BOISSIERE C ET AL: "From hybrid films to mesoorganized multi-metal-oxide nanocrystalline films (M3NF), preparation and characterization", ORGANIC/INORGANIC HYBRID MATERIALS-2004. (MATERIALS RESEARCH SOCIETY SYMPOSIUM PROCEEDINGS ), vol. 847, 2005, pages 135-146, XP002693748, MATERIALS RESEARCH SOCIETY WARRENDALE, PA, USA ISBN: 1-55899-795-4

## Description

### DOMAINE TECHNIQUE DE L'INVENTION

L'invention se rapporte au domaine des nano-objets. Plus particulièrement, l'invention se rapporte à un procédé de fabrication d'une couche mince de nanoreliefs ordonnés de silicium, par plasma (IRE gravure à sec) à l'aide d'un nanomasque réactif RNM auto-organisé dont on contrôle la dimension et la périodicité. L'invention porte sur les couches minces de nanoreliefs obtenus par le procédé et ainsi que sur l'utilisation de nanofils ordonnés de silicium dans de nombreuses applications industrielles.

Les nanofils présentent des caractéristiques électriques particulièrement intéressantes, notamment parce que leur conductivité peut se situer plusieurs ordres de grandeur au-dessus de celle de structures de taille micronique ou submicronique.

### ETAT DE LA TECHNIQUE ANTERIEURE

Depuis quelques années, on sait fabriquer des structures ordonnées de très petites tailles telles que les nanofils de carbone et les nanofils et les nano-bâtonnets de silicium.

Le document FR 2860780 décrit un procédé de fabrication de nanofils de carbone à partir d'une matrice nanoporeuse sur laquelle on dépose un catalyseur métallique. Les nanofils de carbone croissent par épitaxie perpendiculairement à la surface du substrat cristallin.

Le document FR 2888041 décrit également la fabrication de nanofils ou de nanobâtonnets de silicium à partir d'un procédé VLS (vapeur-liquide-solide). Selon ce procédé, on grave des pores creux dans un substrat d'aluminium, on dépose au fond des pores un catalyseur métallique, puis on fait croître des nanofils de silicium, qui peuvent être dopés sélectivement en cours de croissance de manière à générer des fils conducteurs ou des jonctions électroniques de type NIN ou PIP.

Les nanofils obtenus suivant les techniques décrites dans ces documents antérieurs croissent perpendiculairement à la surface sur laquelle est déposé le catalyseur. Pour obtenir des fils parallèles à la surface du substrat, il faut donc former des pores parallèles à cette surface et déposer le catalyseur au fond des pores.

La demande internationale WO 2010/040967 décrit un procédé de fabrication de nanofils semiconducteurs sur un substrat comprenant une couche d'oxyde métallique. Ce procédé comprend : l'exposition de la couche d'oxyde métallique à un plasma d'hydrogène afin de la réduire ; La formation de nanogouttes métalliques en surface de la couche d'oxyde métallique; le dépôt assisté par plasma d'une couche mince d'un matériau semiconducteur sur la couche d'oxyde métallique, la couche mince ayant une épaisseur apte à recouvrir les nanogouttes métalliques ; et enfin le recuit thermique à une température (T), suffisante pour activer une croissance latérale de nanofils par catalyse du matériau déposé en couche mince à partir des nanogouttes métalliques.

Dans les années 2000 à 2010, le développement de méthodes dites bottom-up (du bas vers le haut) pour préparer de grandes surfaces nanostructurées à faible coût est devenu l'une des priorités en matière de nanotechnologie. Le marché de l'électronique organique, couvrant des sujets importants comme l'éclairage, le photovoltaïque organique, l'électronique et les systèmes intégrés intelligents représente un potentiel allant jusqu'à des centaines de milliards de dollars. Les approches Topdown donnent des caractéristiques extrêmement bien définies et des tableaux de motifs périodiques ayant des dimensions de l'ordre de 20 nm ainsi qu'une longue portée. Cependant, ces méthodes sont lentes, coûteuses et ont un faible débit ; elles ne sont donc pas directement appropriées pour la production industrielle.

Les approches bottom-up, à faible coût, sont capables d'autoassembler des matériaux organiques et inorganiques de dimensions beaucoup plus petites, mais elles souffrent d'une petite portée et de la présence de défauts. Toutefois, ces matériaux auto-assemblés peuvent facilement être déposés sur différentes surfaces en utilisant des techniques de dépôt de liquide. Ils peuvent aussi être considérés comme une alternative peu coûteuse ou une étape intermédiaire dans les protocoles de nanofabrication conventionnels.

La nanolithographie, impliquant la gravure à sec d'ions réactifs (RIE), grâce à l'auto-assemblage des nanostentils copolymères séquencés, s'est récemment révélée être une approche efficace pour le transfert d'éléments de 20 à 50 nm, avec une organisation hexagonale ou carrée, sur un wafer de silicium. Lesdits nanomasques de polymères utilisés dans cette technologie sont délicats à préparer et manquent de durabilité. Les membranes alumine anodisées (AA) ont également été utilisées pour transférer des perforations de 70 nm dans du substrat de silicium afin d'améliorer des surfaces optiques d'émission de lumière, mais ces membranes sont très coûteuses et difficiles à manipuler.

JOHNSTON D E ET AL: "Plasma etch transfer of self-assembled polymer patterns",PROCEEDINGS OF THE SPIE - THE INTERNATIONAL SOCIETY FOR OPTICAL ENGINEERING SPIE, vol. 8328, 29 mars 2012 (2012-03-29), XP008160753,THE INTERNATIONAL SOCIETY FOR OPTICAL ENGINEERING USA ISSN: 0277-786X divulge un procédé de fabrication d'une couche mince de nanoreliefs ordonnés de silicium.

### EXPOSE DE L'INVENTION

L'invention a pour but de remédier à des inconvénients de l'état de la technique et concerne plus particulièrement un procédé de fabrication d'une couche mince de nanoreliefs ordonnés de silicium comprenant les étapes suivantes :
A) préparation d'un nanomasque réactif auto-organisé (RNM) constitué de MxM'yOz (avec M = Ca, Mg ; M' = Ti, Zr, Si, Fe, Ce, Al, Hf, Y, Ge, V, Mo, W, Nb, Ta, Sn, In et leurs combinaisons ; x+y=1 ; z dépend du degré d'oxydation de M et M') nommé RNM initial, en utilisant un nanomasque inorganique, INP ;
B) dépôt, par voie liquide dudit RNM initial sur un substrat de silicium ;
C) transfert dudit nanomasque, MxM'yOz, dans le substrat de silicium par gravure à sec, par exposition dudit nanomasque, MxM'yOz, à un gaz plasma fluoré, entre 0,5 et 4 minutes typiquement en fonction de la constitution dudit gaz, transformant le MxM'yOz en un composant stable MF₂ nommé nanomasque intermédiaire, qui permet d'obtenir, soit une couche mince nanoperforée ou soit un réseau ordonné de nanofils de silicium, présentant des dimensions et une périodicité directement liées à celles du RNM initial.

Par « nanoreliefs » on entend des nanoperforations, reliefs en creux ou négatif, vis-à-vis d'une surface de référence ou des nanofils, reliefs positifs (nanofils).

Avantageusement, le nanomasque réactif auto-organisé (RNM), CaₓTi₍₁₋ₓ₎O₍₂₋ₓ₎ est obtenu en choisissant M= Ca ; M'= Ti ; x=0,5 ; y=0,5.

De préférence, dans le procédé selon l'invention le RNM initial, CaₓTi₍₁₋ₓ₎O₍₂₋ₓ₎ présente une épaisseur inférieure ou égale à environ 10 nm.

Avantageusement, dans le procédé de fabrication selon l'invention à l'étape C), la gravure à sec est effectuée dans une ambiance fluorée mixte constituée de gaz SF₆/O₂ ou SF₆/CH₃, et le RNM initial est exposé pendant au moins un cycle audit plasma fluoré afin d'obtenir des nanoreliefs.

Par « cycle » on entend un temps d'exposition au plasma de gravure suivi d'un temps qui peut être entrecoupé de pause pendant lequel le RNM n'est pas exposé au plasma.

Selon un mode de réalisation de l'invention, le RNM initial est exposé à un seul cycle d'exposition au plasma fluoré afin d'obtenir une couche mince nanoperforée pourvue de perforations d'environ 250 nm de profondeur.

De préférence, dans le procédé de fabrication selon l'invention, le RNM initial est exposé successivement à deux cycles d'exposition successifs au plasma fluoré afin d'obtenir une couche mince nanoperforée pourvue de perforations d'environ 350 nm de profondeur.

Avantageusement, le procédé de fabrication du nanomasque réactif comprend les étapes suivantes :
a) dissoudre du chlorure de calcium anhydre dans de l'éthanol absolu et du chlorure de titane (IV) pour obtenir une première solution ;
b) dissoudre du copolymère bi-blocs (butadiène oxyde d'éthylène, PB-PEO) dans de l'éthanol, ajouter ensuite de l'eau pour obtenir une deuxième solution, chauffer ladite deuxième solution à 45° C pendant 2 jours, laisser refroidir ladite deuxième solution à température ambiante afin de produire des micelles mono dispersés ;
c) ajouter la première solution, goutte à goutte, à la deuxième solution obtenue à l'étape (b) afin d'obtenir un mélange ;
d) agiter le mélange obtenu à l'étape (c) pendant une heure avant le dépôt dudit RNM initial.

De préférence, le copolymère bi-blocs (butadiène oxyde d'éthylène, PB-PEO) est soit PB₁₁₂PEO₂₂₇, soit PB₆₄₀PEO₉₈₉.

Selon un mode de réalisation de l'invention, on choisit le copolymère bi-blocs, PB₁₁₂PEO₂₂₇, et on expose le RNM initial à plusieurs cycles successifs du plasma fluoré afin d'obtenir un réseau homogène de nanofils droits d'un diamètre d'environ 20 nm.

Avantageusement, le réseau de nanofils est oxydé thermiquement ou chimiquement, afin de diminuer le diamètre des nanofils.

Plus encore, le réseau de nanofils est recouvert (fonctionnalisé) avec un dépôt de matériaux organiques ou inorganiques, afin de conférer aux nanofils de nouvelles propriétés.

L'invention concerne une couche nanoperforée obtenue par le procédé ci-dessus, utilisée en tant que matrice de croissance pour la réalisation notamment de matériaux hybrides.

L'invention concerne des nanofils de silicium obtenus par le procédé ci-dessus et utilisés dans une matrice de polymère afin d'obtenir des couches minces hybrides, des polymères conducteurs et des polymères luminescents.

L'invention concerne encore des nanofils de silicium ou couches nanoperforées obtenus par le procédé ci-dessus, et à partir d'un substrat de silicium implanté en surface, d'une couche mince SOI ou encore de super-réseaux.

Par implantation on entend appliquer par exemple les ions d'un matériau dans un substrat ou doper un substrat, changeant de ce fait les propriétés physiques de ce substrat.

L'invention concerne en outre l'utilisation d'un réseau de nanofils ordonnés de silicium, obtenu selon le procédé ci-dessus, par exemple dans des applications optiques et/ou photoniques, en particulier pour l'éclairage, photovoltaïque et LED.

L'invention concerne en outre l'utilisation d'un réseau de nanofils ordonnés de silicium obtenu selon le procédé ci-dessus, dans des capteurs chimiques et/ou biologiques.

### BREVE DESCRIPTION DES FIGURES

D'autres caractéristiques, détails et avantages de l'invention ressortiront à la lecture de la description qui suit, en référence aux figures annexées, qui illustrent:

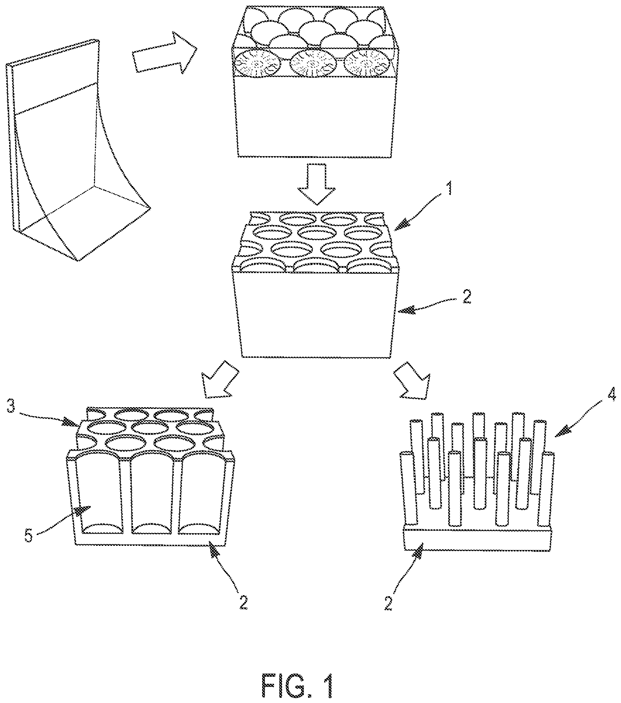

- La figure 1 illustre les étapes utiles à la formation d'une matrice de nanoperforation ou de nanofils en utilisant une approche RNM ;

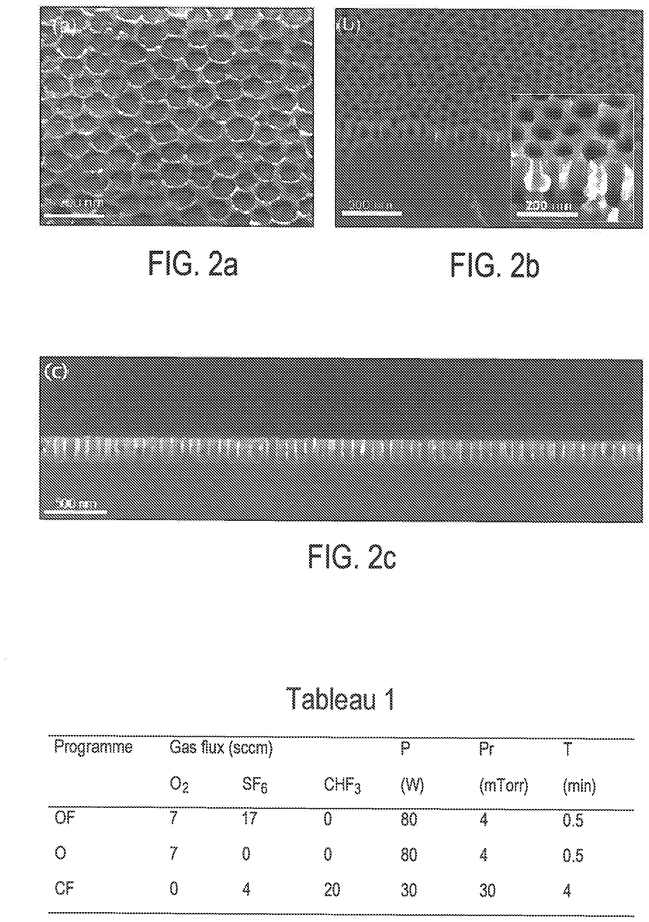

- la figure 2 illustre les images obtenues par FEG-MEB : (a) une vue de dessus du nanomasque (RNM) de calcium titane oxyde, (b) une vue de la surface du silicium, et (c) une vue de profil des motifs transférés sur le substrat de silicium ;
- Le tableau 1 illustre les conditions utilisées pour la gravure à sec ;

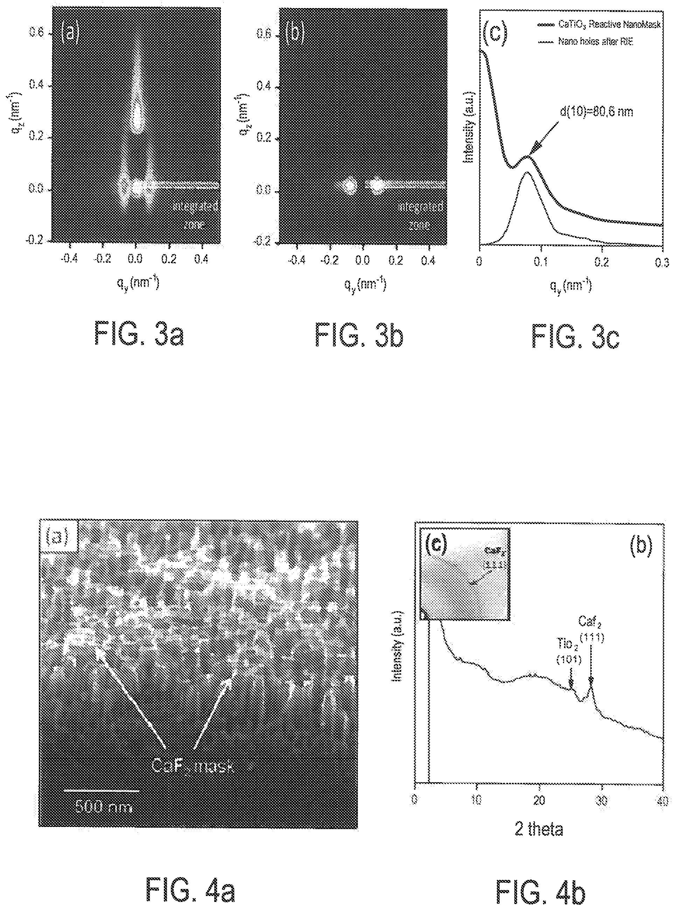

- la figure 3 illustre l'analyse des motifs par la technique GI-SAX : (a) du RNM Ca0,5Ti0,5O1,5 à une périodicité initiale de 80.6 nm (obtenue avec PB640PEO989) , (b) la surface de silicium après la gravure, et (c) les profils d'intensité correspondants, avant la gravure (ligne grise) et après la gravure (ligne noire), dans la direction qy (correspondant aux lignes en pointillés sur les schémas a et b) ;
- la figure 4 illustre : (a) une image obtenue par MEB (Microscopie électronique à balayage), montrant une surface sur-gravée de silicium avec une couche mince perforée de CaF2 résultant de la réaction du RNM avec le plasma fluoré, et (b) l'analyse par la technique GI-SAXS, des anneaux de diffraction qui révèlent la présence de CaF2 cristallin susceptible d'être émis à partir du masque restant ;

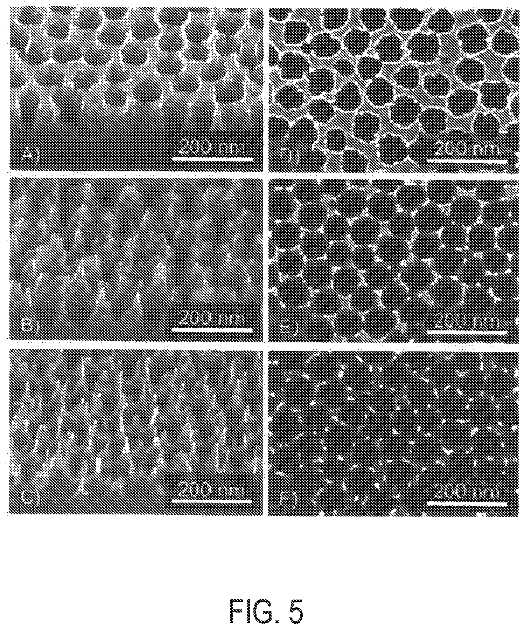

- la figure 5 illustre les images MEB (Microscopie électronique à balayage) des motifs transférés, obtenus en utilisant le programme CF du tableau 1 dans lequel x détermine la quantité de Ca : dans 5(A,D) x=0.375 ; dans 5(B,E) x= 0.250 et dans 5(C,F) x= 0.125 ;

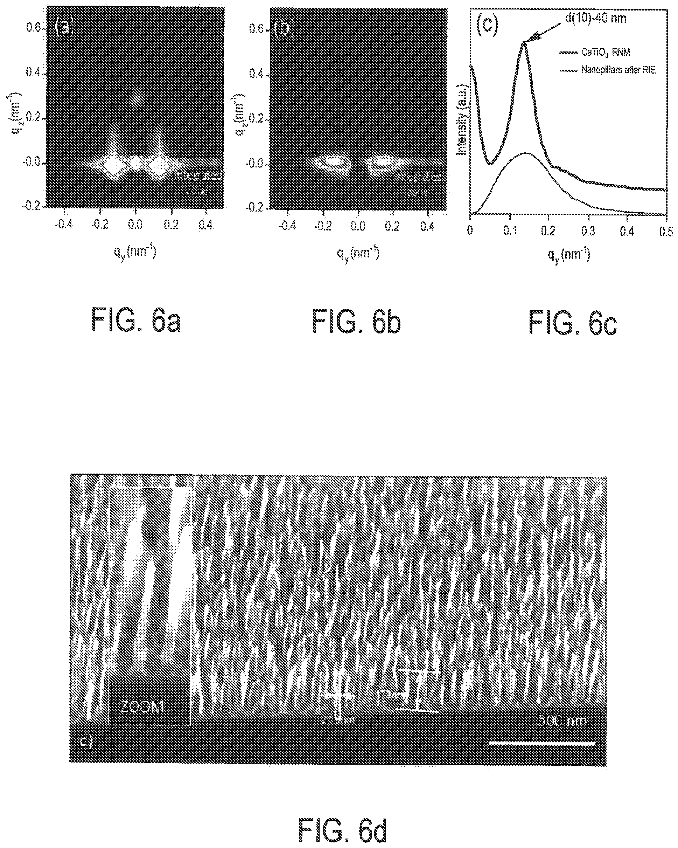

- la figure 6 illustre l'analyse des motifs par la technique GI-SAXS : (a) RNM initial avec une périodicité de 46 nm, (b) la surface du substrat de silicium finale gravée, (c) les profils d'intensité correspondants, avant la gravure (ligne grise) et après la gravure (ligne noire), dans la direction qy (correspondant aux lignes en pointillés sur les schémas a et b), et (d) l'image obtenue par un MEB, de la surface du substrat de silicium après la gravure au travers du RNM perforé de 35 nm (obtenue avec PB112PEO227).

En référence à la figure 1, nous connaissons déjà des nanomotifs inorganiques (INP), qui peuvent être préparés par simple dépôt ou par trempage, d'une seule couche de micelles de copolymère séquencé incorporé dans un précurseur de sol-gel, suivi d'un traitement thermique. Un réglage de la composition chimique de la solution initiale et des conditions de trempage conduit à un INP (nanomasque inorganique) d'oxyde métallique (TiO₂, Al₂O₃, ZrO₂), ultramince (4 à 15 nm d'épaisseur) portant des nanoperforations ordonnées de 12 à 80 nm de diamètre, à travers lesquels la surface d'un substrat (par exemple Si, de verre, FTO, ITO, Au, ou n'importe quelle autre couche poreuse ou dense) est accessible. Ces nanomotifs inorganiques (INP) ont déjà été utilisés pour la croissance sélective locale de nano-objets, en tant que modificateurs de surface pour le mouillage, en tant que composant d'auto-nettoyage des couches anti-reflets, et sous forme de tableaux nanolectrode.

La présente invention a pour objet de montrer comment ces couches INP peuvent être utilisées comme de nouveaux RNMs auto-organisés par un transfert lithographique de gravure à sec. Une particularité des nouveaux RNMs auto-organisés est qu'ils contiennent un agent intermédiaire spécifique, qui peut réagir avec les composants du plasma de gravure pour obtenir un pochoir plus stable et plus sélectif.

Selon l'invention, les INPs par exemple (TiO₂) ont d'abord été associés à Ca²⁺, en remplaçant environ 50% des atomes de titane par du calcium, pour donner un INP RNM, d'oxyde de calcium titane (CaₓTi₍₁₋ₓ₎O₍₂₋ₓ₎), qu'on nomme RNM initial. Une couche dudit RNM initial 1 est appliquée sur un wafer de silicium 2. L'ensemble est ensuite exposé à un plasma à couplage capacitif (CCP) RIE renfermant un gaz fluoré. Dans ce procédé, la présence de Ca²⁺ améliore considérablement la sélectivité et la réactivité chimique lors de la gravure. Cela est dû à la réaction spontanée des ions calcium (Ca²⁺) avec les ions fluorés (F⁻) contenus dans le gaz du plasma, produisant le composé stable CaF₂ qu'on nomme masque intermédiaire. Le composé CaF₂ est extrêmement stable dans les conditions actuelles de gravure. Cette approche simple est illustrée sur la figure 1 et conduit à des perforations 5 dans le silicium 2 ou aux tableaux ordonnés de nanofils verticaux 4 qui présentent des diamètres jusqu'à 70 nm (ici avec PB₆₄₀PEO₉₈₉).

Par auto-organisation on obtient un masque nanostructuré de type « nid abeille ». La figure 2.a est une vue de dessus de la surface d'un wafer de silicium sur lequel le RNM initial auto-organisé (Ca_{0,5}Ti_{0,5}O_{1,5}) est appliqué. L'image montre une organisation quasi compacte des perforations pseudo hexagonales (type nid abeille) ou ronde dont le diamètre moyen est proche de 60 nm. L'épaisseur de la couche de RNM est d'environ 10 nm. On remarque que la surface du wafer de silicium 2 est visible, au fond des perforations. L'analyse de la structure du RNM initial révèle que celui-ci est amorphe et n'adopte pas la stabilité thermo dynamique de la structure CaTiO₃ perovskite, comme prévu et connu pour une telle composition. Cela est probablement dû au traitement thermique qui n'est pas suffisant pour atteindre l'état cristallin. En effet, la formation d'un état cristallin nécessite un chauffage généralement supérieur à 600 C°.

Le tableau 1 définit les paramètres de la gravure pour trois programmes différents, OF, O et CF: la puissance P (en Watt), la pression Pr (en mTorr), et la durée d'exposition T (en min) à un plasma fluoré dont la composition est donnée: O2/SF6 par la première ligne ; 02 par la deuxième ligne ; SF6/CHF3 par la troisième ligne.

Les figures 2.b et 2.c montrent le transfert du réseau de perforations de la figure 2.a après gravure dans une ambiance fluorée mixte, constituée de gaz SF₆/O₂, suivant le programme 'OF' du tableau 1. L'image montre que le dernier réseau est hautement transféré sur le wafer de silicium, on obtient donc une couche nanoperforée dont l'épaisseur est contrôlée par le temps de gravure. Les perforations ont le même diamètre que les perforations initiales et avec une profondeur de gravure de 250 nm, correspondant donc à un rapport 4 entre la profondeur et le diamètre des perforations. En effet, dans ces conditions, suite à la gravure de silicium, le tétrafluorure de silicium (SiF₄) volatile est formé et, le SiOₓF_{y} déposé à la surface du silicium agit comme une couche de passivation qui ralentit la gravure latérale. De plus, l'épaisseur du RNM, qui est d'environ 10 nm, permet une gravure anisotrope d'au moins 250 nm du wafer de silicium 2.

La figure 3 présente les motifs initiaux et finaux obtenus avec une technique d'analyse GI-SAX, de diffusion de rayon-X sur un substrat de silicium, avec un angle d'incidence rasante de 0,2°. Avant la gravure (fig.3a), les barres parallèles de diffraction, situées à q_{y} = 0,078 nm⁻¹, sont caractéristiques de tableaux homogènes nanoperforés avec une périodicité de 80,6 nm, ce qui est en accord avec l'organisation pseudo hexagonale observée sur les images de la figure 2. La présence de barres de diffraction est due à des signaux d'interférence s'étendant par évanescence au travers de la couche mince du RNM initial, ce qui est typique d'une couche mince unique de motifs périodiquement organisés. Après la gravure (fig.3b), le même pic de diffraction est observé le long de la direction q_{y}, comme le montrent les courbes de profil d'intensité de la figure 3c. Ainsi l'organisation initiale a été conservée.

Selon la figure 3.b, l'organisation latérale de la perforation du RNM initial a été correctement transférée au substrat de silicium. La disparition des barres de diffraction dans la direction q_{z} (q_{y} = 0,078 à nm⁻¹) est due à la profondeur sensiblement augmentée, des perforations. Cette disparition provient d'une absorption du signal de diffraction des rayons X et de l'augmentation de la fréquence d'interférence dans le plan (_{y,z}). Le signal observé pour le RNM initial, qui a un q_{y} faible, correspond à la réflexion spéculaire du faisceau incident de rayons X à la surface du substrat de silicium. Cette réflexion spéculaire n'est plus visible après la gravure, suite à la rugosité accrue de la surface associée à l'augmentation de la profondeur de perforation, qui favorise la diffusion.

La figure 4a montre l'image du RNM initial, Ca_{0.5}Ti_{0,5}O_{1,5}, exposé successivement à deux cycles ou programmes de gravure, un premier programme 'OF' et un second programme 'O'. (Les conditions des programmes OF et O sont décrites dans le tableau 1). L'image obtenue révèle des perforations, présentant une profondeur d'environ 350 nm, qui ont tendance à présenter près de la surface une section transversale plus faible qu'en profondeur.. On remarque que la profondeur des perforations n'est pas double par rapport au cas selon lequel le RNM est exposé à un seul cycle de programme 'OF'. On en déduit que la vitesse de la gravure diminue avec la profondeur des perforations. La vitesse de gravure n'est pas linéaire ; cela est probablement dû à la diminution de la diffusivité de la gravure et à l'évacuation du produit. Ce phénomène induit une vitesse de gravure latérale plus rapide en haut de la surface gravée qu'en bas. Pour ces raisons, le deuxième cycle de gravure n'attaque pas avec la même anisotropie que le premier cycle.

Sur la figure 4a, une fine membrane nanoperforée est clairement visible. Il est probable que cette membrane correspond à une sorte de « reste » du RNM initial. En effet, sur les figures 4(b et c), on voit un pic de diffraction situé à un angle (2 theta) 2 • = 29° qui ne correspond pas au silicium ni à aucune phase d'oxyde de titane, mais au plan (111) correspondant à la structure de CaF₂. En effet, le RNM initial Ca_{0,5}Ti_{0,5}O_{1,5}, lors de la réaction avec le plasma fluoré, a été transformé en CaF₂ cristallin. On peut conclure que l'augmentation de la vitesse de gravure latérale, au-dessus d'une profondeur critique, est intrinsèquement liée à la technologie de gravure à sec et non à la stabilité du nanomasque CaF₂. Comme l'épaisseur du nanomasque initial (RNM initial) est d'environ 10 nm, lorsque le taux de gravure anisotrope a été mesuré à au moins 250 nm pour 1 cycle, on déduit que le taux de sélectivité de gravure entre le CaF₂ et le silicium est d'au moins 25:1. Ainsi, le faible pic et le large pic observés sur la figure 4b correspondent respectivement à 2 • = 20° et 2 • = 25°; Ils sont respectivement attribués à la silice amorphe et aux traces de TiO2 cristaux restants du masque RNM initial.

Dans le processus de gravure avec une puissance radiofréquence élevée, d'environ 80 W (programme O ou OF du tableau 1), la densité du plasma est élevée, ce qui entraîne une gravure plus rapide. Selon un autre mode de réalisation de la présente invention, le RNM initial est soumis à RIE (gravure) en mode puissance radiofréquence basse. Dans ce mode de réalisation les conditions des programmes OF et O (du tableau 1) ne sont pas adaptées, car dans ces programmes, la puissance P de radiofréquence est élevée, (de l'ordre de 80W). Selon le programme CF du tableau 1, la composante passivation O₂ de l'atmosphère a été remplacée par CHF₃. Une durée d'exposition plus longue est nécessaire mais une puissance à l'ordre de 30 W, plus faible, que pour les programmes OF et O, est requise. Nous allons étudier l'efficacité du RNM avec diverses quantités de calcium (Ca) en appliquant le programme CF.

La figure 5 montre une série d'images, obtenues avec un MEB (Microscopie électronique à balayage) d'un motif transféré sur trois substrats de silicium différents, gravé selon le programme CF, sur un cycle d'exposition, et en utilisant le RNM CaₓTi₍₁₋ₓ₎2₍₂₋ₓ₎, avec x = 0,375 dans les figures 5 (A,D); x = 0,250 dans les figures 5 (B,E); et x = 0,125 dans les figures 5 (C,F).

Pour x = 0,375, on remarque qu'il n'y a pas de différence significative par rapport aux transferts des motifs obtenus pour x = 0,5 avec le programme OF tel qu'illustré par les fig. 2a et 2b. Cependant, la profondeur de gravure obtenue dans ces conditions est de 160 nm pour une durée d'exposition de 4 min.

Pour des concentrations plus faibles de Ca dans le RNM, i.e. pour (x = 0,250 et x = 0.125), un processus de transfert correct n'est plus possible. En supposant, sur les figures 5, que les parties blanches correspondent aux matériaux CaF₂, on remarque que le nanomasque CaF₂ devient de plus en plus déconnecté et dispersé avec la diminution de la quantité de Ca. Ceci est du à la diminution de la conductivité électronique du silicium. Sur les figures 5E et 5F les points lumineux blancs discrets correspondent aux nanoparticules CaF₂, ceci conduit logiquement après gravure à la formation de nanofils comme on le voit sur les figures 5B et 5C.

La formation de nanofils obtenus selon les figures 5B et 5C, confirme la stabilité et le rôle protecteur de la phase CaF₂ dans le processus de gravure (RIE). Cependant, il révèle aussi que, pour des quantités de Ca trop faibles, seules les petites parties de CaF₂ peuvent être stabilisées par réaction avec le plasma, et qu'un transfert correct du RNM initial est perdu. Par conséquent, puisqu'on peut transformer le RNM initial, CaₓTi₍₁₋ₓ₎0₍₂₋ₓ₎, en dispersions homogènes de nanoparticules CaF₂, il est possible de les utiliser sous forme de nanomasques particuliers pour produire un réseau de nanofils ayant des dimensions et une périodicité déterminés par la taille et la dispersion des nanoparticules CaF₂.

Dans un mode de réalisation de l'invention illustré par les figures 6a à 6d, un RNM initial Ca_{0,5}Ti₀,₅O₁,₅ a été préparé, en utilisant le copolymère bi-blocs PB₁₁₂PEO₂₂₇ comme modèle. Ceci conduit à des perforations de 35 nm de diamètre ayant une périodicité d'environ 46 nm comme on le voit sur la figure 6a avec (q_{y} = 0,135 nm⁻¹). Par rapport au RNM précédent avec de grandes perforations, ici, l'ordre est mieux conservé en raison de la diminution d'entropie associée à la plus petite longueur de la chaîne de polymère. La gravure a été réalisée en utilisant successivement 4 cycles de programme (OF et O) avec une puissance élevée, environ 80 W ; ceci conduit à une surface sur-gravée comme le montre la figure 6a. L'image de la surface résultante de la figure 6d montre un réseau homogène de nanofils droits qui ont une hauteur d'environ 173 nm et un diamètre d'environ 20 nm. On remarque qu'au sommet des nanofils, il n'y a pas de trace de nanoparticules CaF₂, ce qui montre que, sous cette condition, le CaF₂ a été entièrement éliminé.

La figure 6b montre la surface finale du substrat de silicium après la gravure. Cette figure révèle de larges pics de diffraction selon la direction q_{y}, avec un espacement « d », d'environ 45 nm, similaire à ceux du RNM initial, comme montrent les courbes de profil d'intensité de la figure 6c. La fig. 6c montre les courbes de profils d'intensité avant la gravure (ligne grise) et après la gravure (ligne noire), dans la direction q_{y} (correspondant aux lignes en pointillés sur les images 6a et 6b). Ceci montre que l'organisation initiale a été conservée. La disparition des barres de diffraction et la réflexion spéculaire le long de la direction q_{z} sont encore une fois liées à la profondeur de la gravure et à la rugosité de la surface. La largeur de la crête est due au fait que la base des nanofils est située dans la position du RNM initial, avec la même périodicité moyenne, mais avec une distribution plus large. (figure 6d).

Avec des procédés issus de l'état de la technique, en plusieurs étapes parfois très compliquées, on pouvait au mieux obtenir des nanoparticules présentant une dimension maximum de 20 nm, en utilisant des membranes (AA). Le même résultat peut être obtenu aisément avec le RNM auto-organisé de la présente invention, en seulement deux étapes. En outre, le nanomasque, selon l'invention permet d'obtenir des nanofils ayant un rapport d'environ 8 entre leur hauteur et leur diamètre. Un tel rapport entre hauteur et diamètre de nanofils n'a jamais été réalisé jusqu'à présent.

Les figures 3 et 6 permettent de confirmer que la totalité de la surface est composée de motifs ayant une dimension, une morphologie, et une distribution homogènes. Elles montrent également la distance de corrélation entre les motifs nanoperforations (figure 4) et nanofils (figure 6).

Avantageusement, la présente invention conduit à la formation d'une couche mince de nanoperforations ou d'un réseau de nanofils quasi-ordonnés concernant la transformation des perforations du RNM initial, CaₓTi₍₁₋ₓ₎O₍₂₋ₓ₎, en un réseau de nanoparticules discontinue CaF₂ au cours de la gravure par plasma. Les différences principales de la morphologie finale des nanofils trouvent leur origine dans le contenu de Ca du RNM, dans la dimension et la périodicité de la plus petite perforation, ainsi que dans la durée de la gravure (un ou plusieurs cycles successifs). Autrement dit la combinaison de tout ou partie de ces paramètres est à l'origine de la morphologie finale des nanofils.

De plus, la tranformation d'une couche mince nanoperforée en un réseau de nanofils est d'autant plus rapide que la période des perforations est faible. C'est ce qui est observé sur la figure 6 ou la partie la plus étroite est érodée très rapidement pour ensuite permettre une gravure anisotrope aboutissant à des nanofils droits d'environ 20 nm de diamètre. Cet effet est un avantage, puisque l'exaltation des propriétés physiques ou chimiques des nanofils est inversement proportionnelle à leurs tailles.

Après l'obtention de couches mince nanoperforées ou le réseau de nanofils, on peut procéder à des traitements post-gravure, par exemple, on peut oxyder thermiquement ou chimiquement les nanofils. Cela a pour effet de diminuer la proportion de silicium et donc le diamètre des nanofils. La couche oxydée ainsi obtenue a pour effet de passiver la surface des nanofils.

On peut également encapsuler ou recouvrir les nanofils obtenus avec un dépôt de matériaux organiques ou inorganiques conférant auxdits nanofils de nouvelles propriétés. Un exemple simple, desdits traitements serait d'encapsuler les nanofils obtenus à partir d'un substrat de silicium de type n dans un polymère semi-conducteur de type p. Les couches sont ensuite rendues planes jusqu'à faire affleurer la partie haute des nanofils. Le contact électrique supérieur est ensuite obtenu par métallisation d'un film métallique mince fin ou TCO afin d'obtenir des jonctions hybrides.

Selon la présente invention, en termes de formation de CaF₂, la réaction chimique globale peut se résumer par l'équation (1), suivante :

CaₓTi₍₁₋ₓ₎O₂₋ₓ₍ₛ₎ + SF₆₍ᵥ₎ → xCaF₂₍ₛ₎ + (1-x)TiO_{y}F_{z(v)} +SOᵤF_{w(v)} (1)

Les valeurs y, z, u et w dépendent des conditions de la gravure (pression, puissance, présence de O₂ ou de CHF₃, gaz fluoré utilisé). L'indice (s) correspond à un composé solide tandis que l'indice (v) correspond à une phase vapeur. Le RNM initial est rapidement transformé, en présence de gaz de fluore, en une nanoparticule stable CaF₂ qui compose principalement le nanomasque résultant intermédiaire, hautement sélectif. La gravure (RIE) est responsable de la formation des nanoperforations. Sur un traitement plus long, l'oxyde de titane est progressivement éliminé du masque, et les CaF₂ commencent à se fritter dans des conformations plus stables que sont des réseaux de nanoparticules discontinus. À ce stade, il ne devrait plus se produire de frittage, et la taille moyenne des nanoparticules dépend de la distance de séparation des perforations du RNM initial; leur périodicité reste très proche de la distance de corrélation de perforation du RNM initial. Le transfert du RNM sur le wafer de silicium correspond donc à un problème cinétique entre la vitesse de formation des nanoparticules CaF₂ et le taux d'élimination du Si. Comme déjà expliqué précédemment, le taux d'élimination du Si est plus ou moins constant depuis le début de la gravure et il décroît au fur et à mesure que l'on s'éloigne de la surface. Le mécanisme de frittage du CaF₂ est régi par la diffusion ainsi que par les contraintes internes créées par la courbure inter faciale de la perforation. Le taux de frittage, et donc la vitesse de formation des particules discrètes CaF₂, est inversement proportionnel à la teneur en Ca et au rayon de cette courbure. Par conséquent, si on souhaite obtenir des objets discrets tels que des nanofils, il faut favoriser le frittage rapide et ralentir la vitesse de gravure. La taille et la périodicité des motifs finaux peuvent être contrôlées par la teneur en Ca et la dimension de perforation du RNM initial. D'autre part, pour obtenir des nanoperforations, on fait face à la limite de la gravure latérale due à la diffusion, mais il est préférable de favoriser une vitesse de gravure rapide et une haute teneur en Ca, tandis que les dimensions latérales des nanoperforations sont corrélées au RNM initial.

### Exemple d'un procédé de préparation du RNM.

Des couches de RNM auto-organisé, CaₓTi₍₁₋ₓ₎O₍₂₋ₓ₎, ont été préparées à partir d'une solution de chlorure de calcium et de chlorure de titane en présence d'agents micellaires. Du chlorure de calcium anhydre (Aldrich, 1,3 g ou 11,8 mmol) a été dissout dans 20,3 g d'éthanol absolu et 3,35 g de chlorure de titane (IV) pour obtenir une première solution. Le Poly (*butadiène oxyde* d'éthylène, PB-PEO) (0,03 g) soit 15 600 g mol⁻¹ de PB₁₁₂PEO₂₂₇, Source Polymère P2753 ou 75500 g mol⁻¹ de PB₆₄₀PEO₉₈₉, Source Polymère P2325 est dissout dans 5 g d'éthanol, puis 0,25 g d'eau est ajouté pour obtenir une deuxième solution. Cette deuxième solution est ensuite chauffée à 45° C pendant 2 jours et refroide à température ambiante afin de produire des micelles mono disperses. Ensuite 0,37 g de la première solution (chlorure de calcium et chlorure de titane (IV)) est ajoutée, goutte à goutte, à cette deuxième solution. Le mélange obtenu est agité pendant une heure avant son dépôt sur le substrat de silicium. Les rapports molaires typiques des solutions initiales sont de 1-x TiCl₄ / x CaCl₂ / 0,75 EO / 40 H₂O / 215 EtOH (x varie entre 0,12 et 0,5 g et EO correspond à des unités d'oxyde d'éthylène de la chaîne de PEO). Avant le dépôt du mélange, le substrat de silicium est lavé de préférence avec de l'acétone, du HNO₃, de l'eau, et enfin avec de l'éthanol. Un traitement thermique compris entre 150 et 500° C pendant 5 minest ensuite appliqué sous une lampe infrarouge. Puis le substrat de silicium subit une gravure anisotrope par gravure ionique réactive (RIE) en utilisant le SF₆/0₂ comme gaz fluoré, avec le programme OF (tel que défini ci-avant), ou en utilisant le SF₆/CHF₃ comme gaz fluoré, avec le programme CF (tel que défini ci-dessus). Les paramètres de la gravure, RIE (puissance, gaz, pression et durée) sont définis dans le tableau 1 pour les programmes OF et CF et O. La plus grande puissance utilisée (80 W) dans les programmes OF et O permet des vitesses de gravure élevées. Les programmes OF et O ont été développés pour une sélectivité élevée de gravure de silicium par rapport à une photorésine.

Le procédé d'écrit ci-dessus est un exemple de préparation du RNM. Sans sortir du cadre de l'invention ledit RNM peut être obtenu avec d'autres procédés. De plus, les rapports molaires des solutions initiales dans le procédé de préparation ainsi que et leurs traitements thermiques peuvent être modifiés sans changer le résultat final.

De nombreux types de nanofils verticaux, avec des hauteurs et des diamètres différents, peuvent être obtenus avec le procédé selon l'invention. Le TiO₂ pourra être remplacé par Al₂O₃ (oxyde d'aluminium) ou ZrO₂ (oxyde de zirconium) ou autre ; le calcium (Ca) pourra être remplacé par du magnésium (Mg) sans sortir du cadre de l'invention. L'homme du métier choisira l'un ou l'autre, en fonction des contraintes économiques ou autres qu'il devra respecter.

Basé sur une attaque plasma, le procédé selon l'invention permet de réaliser des nanofils de silicium pur ou des alliages suivant le substrat de départ, couche mince de départ, ou encore super-réseaux à partir desquels l'attaque est réalisée. Par exemple, on peut réaliser des nanofils de silicium ou des nanojonctions pn à partir d'un substrat fortement implanté en surface ou encore des nanofils sur des substrats isolants en partant d'un substrat SOI (couche mince de silicium sur couche d'oxyde elle-même sur substrat de silicium).

De nombreuses applications (capteur, photovoltaique, LED) sont associées aux nanofils de silicium mais elles sont fortement dépendantes du développement de procédés de nanofabrication ainsi que du coût de la synthèse. Le procédé selon l'invention permet une synthèse à bas coût et de ce fait il est compatible avec une production en masse et à grande échelle.

Le procédé selon l'invention peut s'appliquer entre autres aux domaines de l'optique et de la photonique, particulièrement, aux domaines des photovoltaïques, LED, et l'éclairage. De plus, ledit procédé peut s'appliquer à la mise en œuvre de capteurs chimiques ou biologiques.

## Revendications

1. Procédé de fabrication d'une couche mince de nanoreliefs (4, 5) ordonnés de silicium, **caractérisé par** les étapes suivantes :
A) préparation d'un nanomasque réactif auto-organisé, RNM, (1) constitué de MxM'yOz, avec M = Ca, Mg ; M' = Ti, Zr, Si, Fe, Ce, Al, Hf, Y, Ge, V, Mo, W, Nb, Ta, Sn, In et leurs combinaisons ; x+y=1 ; z dépend du degré d'oxydation de M et M', nommé RNM initial, en utilisant un nanomasque inorganique, INP ;
B) dépôt, par voie liquide dudit RNM initial (1) sur un substrat (2) de silicium ;
C) transfert dudit nanomasque, MxM'yOz, dans le substrat (2) de silicium par gravure à sec, par exposition dudit nanomasque, MxM'yOz, à un gaz plasma fluoré, entre 0,5 et 4 minutes typiquement en fonction de la constitution dudit gaz, transformant le MxM'yOz en un composant stable MF2 (3) nommé nanomasque intermédiaire, qui permet d'obtenir, soit une couche mince nanoperforée (5) soit un réseau ordonné de nanofils (4) de silicium, présentant des dimensions et une périodicité liées à celles du RNM initial.

2. Procédé de fabrication d'une couche mince de nanoreliefs ordonnés (4, 5) de silicium selon la revendication 1, dans lequel ledit nanomasque réactif, RNM, CaₓTi₍₁₋ₓ₎O₍₂₋ₓ₎ (1) est obtenu en choisissant M= Ca ; M'= Ti ; x=0,5 ; y=0,5.

3. Procédé de fabrication d'une couche mince de nanoreliefs ordonnés (4,5) de silicium selon l'une des revendications 1 à 2, dans lequel l'épaisseur dudit RNM initial (1) est inférieure ou égale à environ 10 nm.

4. Procédé de fabrication d'une couche mince de nanoreliefs ordonnés (4, 5) de silicium selon la revendication 1, dans lequel la gravure à sec est effectuée dans une ambiance fluorée mixte constituée de gaz SF6/O2 ou SF6/CH3, et le RNM initial est exposé pendant au moins un cycle audit plasma fluoré afin d'obtenir des nanoreliefs.

5. Procédé de fabrication d'une couche mince de nanoreliefs ordonnés (4,5) de silicium selon la revendication 4, dans lequel le RNM initial est exposé à un seul cycle d'exposition au plasma fluoré afin d'obtenir une couche mince nanoperforée (5) pourvue de perforations d'environ 250 nm de profondeur.

6. Procédé de fabrication d'une couche mince de nanoreliefs ordonnés (4,5) de silicium selon la revendication 4, dont le RNM initial est exposé successivement à deux cycles d'exposition au plasma fluoré afin d'obtenir une couche mince nanoperforée (5) pourvue de perforations d'environ 350 nm de profondeur.

7. Procédé de fabrication d'une couche mince de nanoreliefs ordonnés (4, 5) de silicium selon la revendication 1, selon lequel l'étape de préparation du nanomasque réactif comprend les étapes suivantes :
a) dissoudre du chlorure de calcium anhydre dans de l'éthanol absolu et du chlorure de titane (IV) pour obtenir une première solution;
b) dissoudre du copolymère bi-blocs butadiène oxyde d'éthylène, PB-PEO, dans de léthanol, ajouter ensuite de l'eau pour obtenir une deuxième solution, chauffer ladite deuxième solution à 45° C pendant 2 jours et laisser refroidir ladite deuxième solution à température ambiante afin de produire des micelles mono dispersés ;
c) ajouter la première solution, goutte à goutte, à la deuxième solution obtenue à l'étape b) afin d'obtenir un mélange ;
d) agiter le mélange obtenu à l'étape c) pendant une heure avant le dépôt dudit RNM initial.

8. Procédé de fabrication d'une couche mince de nanoreliefs ordonnés (4,5) de silicium selon la revendication 7, dont le copolymère bi-blocs butadiène oxyde d'éthylène, PB-PEO, est soit PB₁₁₂PEO₂₂₇, soit PB₆₄₀PEO₉₈₉.

9. Procédé de fabrication d'une couche mince de nanoreliefs ordonnés (4,5) de silicium selon l'une des revendications 7 ou 8, dans lequel on choisit le copolymère bi-blocs, PB₁₁₂PEO₂₂₇, et on expose le RNM initial (1) à plusieurs cycles successifs du plasma fluoré afin d'obtenir un réseau homogène de nanofils (4) droits d'un diamètre d'environ 20 nm.

10. Procédé de fabrication d'une couche mince de nanoreliefs ordonnés (4,5) de silicium selon la revendication 9, dans lequel le réseau de nanofils (4) est oxydé thermiquement ou chimiquement, afin de diminuer le diamètre des dits nanofils.

11. Procédé de fabrication d'une couche mince de nanoreliefs ordonnés (4,5) de silicium selon la revendication 9, dans lequel le réseau de nanofils (4) est recouvert par un dépôt de matériaux organiques ou inorganiques, afin de conférer auxdits nanofils de nouvelles propriétés.

12. Couche nanoperforée obtenue par le procédé selon l'une des revendications 1 à 7, utilisée en tant que matrice de croissance pour la réalisation notamment de matériaux hybrides.

13. Nanofils de silicium obtenus par le procédé selon l'une des revendications 9 à 11, utilisés dans une matrice de polymère afin d'obtenir des couches minces hybrides, des polymères conducteurs et des polymères luminescents.

14. Utilisation d'un réseau de nanofils ordonnés de silicium obtenu selon l'une des revendications 9 ou 10, dans des applications optiques et/ou photoniques, pour l'éclairage, photovoltaïque et LED.

15. Utilisation d'un réseau de nanofils ordonnés de silicium obtenu selon l'une des revendications 9 à 10, dans des capteurs chimiques et/ou biologiques.

## Patentansprüche

1. Verfahren zur Herstellung einer Dünnschicht auf geordneten Siliciumnanomustern (4, 5), **gekennzeichnet durch** die folgenden Schritte:
A) Herstellen einer selbstorganisierten reaktiven Nanomaske, (RNM), (1), bestehend aus MxM'yOz, mit M = Ca, Mg; M' = Ti, Zr, Si, Fe, Ce, Al, Hf, Y, Ge, V, Mo, W, Nb, Ta, Sn, In und ihren Kombinationen; x+y=1; z hängt vom Oxidationsgrad von M und M' ab, bezeichnet als Ausgangs-RNM, bei Verwendung einer anorganischen Nanomaske, INP;
B) Aufbringen, auf flüssigem Weg, der Ausgangs-RNM (1) auf ein Siliciumsubstrat (2);
C) Transferieren der Nanomaske, MxM'yOz, in das Siliciumsubstrat (2) durch Trockenätzen, durch Aussetzen der Nanomaske, MxM'yOz, gegenüber einem fluorierten Plasmagas zwischen 0,5 und 4 Minuten in typischer Weise in Abhängigkeit von der Konstitution des Gases, wobei das MxM'yOz in eine stabile Komponente MF2 (3), bezeichnet als Übergangs-Nanomaske, umgewandelt wird, die erlaubt, entweder eine nanoperforierte Dünnschicht (5) oder ein geordnetes Netz aus Siliciumnanofäden (4) zu erhalten, mit Dimensionen und einer Periodizität, die mit denen der Ausgangs-RNM verbunden sind.

2. Verfahren zur Herstellung einer Dünnschicht auf geordneten Siliciumnanomustern (4, 5) nach Anspruch 1, wobei die reaktive Nanomaske, (RNM) , CaₓTi₍₁₋ₓ₎O₍₂₋ₓ₎ (1) durch Wählen von M = Ca; M' = Ti; x=0,5; y=0,5 erhalten wird.

3. Verfahren zur Herstellung einer Dünnschicht aus geordneten Siliciumnanomustern (4, 5) nach einem der Ansprüche 1 bis 2, wobei die Stärke der Ausgangs-RNM (1) kleiner oder gleich zirka 10 nm ist.

4. Verfahren zur Herstellung einer Dünnschicht aus geordneten Siliciumnanomustern (4, 5) nach Anspruch 1, wobei das Trockenätzen in einer gemischten fluorierten Atmosphäre durchgeführt wird, bestehend aus Gas SF6/02 oder SF6/CH3, und die Ausgangs-RNM während mindestens einem Zyklus dem fluorierten Plasma exponiert wird, um Nanomuster zu erhalten.

5. Verfahren zur Herstellung einer Dünnschicht aus geordneten Siliciumnanomustern (4, 5) nach Anspruch 4, wobei die Ausgangs-RNM während einem einzigen Expositionszyklus dem fluorierten Plasma exponiert wird, um eine nanoperforierte Dünnschicht (5) zu erhalten, die mit Perforationen einer Tiefe von zirka 250 nm versehen ist.

6. Verfahren zur Herstellung einer Dünnschicht aus geordneten Siliciumnanomustern (4, 5) nach Anspruch 4, dessen Ausgangs-RNM nacheinander während zwei Expositionszyklen dem fluorierten Plasma exponiert wird, um eine nanoperforierte Dünnschicht (5) zu erhalten, die mit Perforationen einer Tiefe von zirka 350 nm versehen ist.

7. Verfahren zur Herstellung einer Dünnschicht aus geordneten Siliciumnanomustern (4, 5) nach Anspruch 1, wobei der Schritt der Herstellung der reaktiven Nanomaske die folgenden Schritte umfasst:
a) Lösen von wasserfreiem Calciumchlorid in absolutem Ethanol und von Titanchlorid (IV), um eine erste Lösung zu erhalten;
b) Lösen von Diblockcopolymer Butadienethylenoxid, PB-PEO, in Ethanol, danach Hinzufügen von Wasser, um eine zweite Lösung zu erhalten, Erhitzen der zweiten Lösung auf 45° C während 2 Tagen und Abkühlen der zweiten Lösung bei Raumtemperatur, um monodispergierte Micellen herzustellen;
c) tropfenweises Hinzufügen der ersten Lösung in die zweite Lösung von Schritt b), um ein Gemisch zu erhalten;
d) Schütteln des in Schritt c) erhaltenen Gemischs während einer Stunde vor dem Absetzen der Ausgangs-RNM.

8. Verfahren zur Herstellung einer Dünnschicht aus geordneten Siliciumnanomustern (4, 5) nach Anspruch 7, deren Diblockcopolymer Butadienethylenoxid, PB-PEO, entweder PB₁₁₂PE0₂₂7 oder PB₆₄₀PEO₉₈₉ ist.

9. Verfahren zur Herstellung einer Dünnschicht aus geordneten Siliciumnanomustern (4, 5) nach einem der Ansprüche 7 oder 8, wobei das Diblockcopolymer PB₁₁₂PEO₂₂₇ ausgewählt wird und die Ausgangs-RNM (1) während mehreren aufeinanderfolgenden Zyklen dem fluorierten Plasma exponiert wird, um ein homogenes Netz gerader Nanofäden (4) mit einem Durchmesser von zirka 20 nm zu erhalten.

10. Verfahren zur Herstellung einer Dünnschicht aus geordneten Siliciumnanomustern (4, 5) nach Anspruch 9, wobei das Netz aus Nanofäden (4) thermisch oder chemisch oxidiert wird, um den Durchmesser der Nanofäden zu verringern.

11. Verfahren zur Herstellung einer Dünnschicht aus geordneten Siliciumnanomustern (4, 5) nach Anspruch 9, wobei das Netz aus Nanofäden (4) von einer Ablagerung organischer oder anorganischer Materialien bedeckt ist, um den Nanofäden neue Eigenschaften zu verleihen.

12. Nanoperforierte Schicht, erhalten nach dem Verfahren nach einem der Ansprüche 1 bis 7, die als Wachstumsmatrix für die Herstellung insbesondere von Hybridmaterialien verwendet wird.

13. Siliciumnanofäden, erhalten nach dem Verfahren nach einem der Ansprüche 9 bis 11, die in einer Polymermatrix verwendet werden, um hybride Dünnschichten, leitende Polymere und lumineszierende Polymere zu erhalten.

14. Verwendung eines Netzes geordneter Siliciumnanofäden, erhalten nach einem der Ansprüche 9 oder 10, in optischen und/oder photonischen Anwendungen für die Beleuchtung, Photovoltaik und LED.

15. Verwendung eines Netzes geordneter Siliciumnanofäden, erhalten nach einem der Ansprüche 9 bis 10, in chemischen und/oder biologischen Sensoren.

## Claims

1. Method for manufacturing a thin film of ordered silicon nanopatterns (4,5), **characterised by** the following steps:
A) preparing a self-organised reactive nanomask, RNM (1) consisting of MxM'yOz, with M = Ca, Mg; M' = Ti, Zr, Si, Fe, Ce, Al, Hf, Y, Ge, V, Mo, W, Nb, Ta, Sn, In and the combinations thereof; x+y=1; z depends on the degree of oxidation of M and M', referred to as initial RNM, using an inorganic nanomask, INP;
B) the liquid deposition of said initial RNM (1) on a silicon substrate (2);
C) transferring said nanomask, MxM'yOz, to the silicon substrate (2) by dry etching, by exposing said nanomask, MxM'yOz, to a fluorinated plasma gas, for 0.5 to 4 minutes typically according to the constitution of said gas, transforming the MxM'yOz into a stable MF2 component (3) referred to as intermediate nanomask, which makes it possible to obtain either a nanoperforated thin film (5) or an ordered lattice of silicon nanowires (4), which has dimensions and a period linked to those of the initial RNM.

2. Method for manufacturing a thin film of ordered silicon nanopatterns (4,5) according to claim 1, wherein said reactive nanomask, RNM, CaₓTi₍₁₋ₓ₎O_{(2-X)} (1) is obtained by choosing M= Ca; M'= Ti; x=0,5; y=0,5.

3. Method for manufacturing a thin film of ordered silicon nanopatterns (4,5) according to one of claims 1 to 2, wherein the thickness of said initial RNM (1) is less than or equal to about 10 nm.

4. Method for manufacturing a thin film of ordered silicon nanopatterns (4,5) according to claim 1, wherein the dry etching is carried out in a mixed fluorinated ambiance formed of SF6/O2 or SF6/CH3 gas, and the initial RNM is exposed for at least one cycle to said fluorinated plasma so as to obtain nanopatterns.

5. Method for manufacturing a thin film of ordered silicon nanopatterns (4,5) according to claim 4, wherein the initial RNM is exposed to a single cycle of exposure to the fluorinated plasma so as to obtain a nanoperforated thin film (5) provided with perforations of about 250 nm in depth.

6. Method for manufacturing a thin film of ordered silicon nanopatterns (4,5) according to claim 4, of which the initial RNM is successively exposed to two cycles of exposure to the fluorinated plasma so as to obtain a nanoperforated thin film (5) provided with perforations of about 350 nm in depth.

7. Method for manufacturing a thin film of ordered silicon nanopatterns (4,5) according to claim 1, according to which the step of preparing the reactive nanomask comprises the following steps:
a) dissolving anhydrous calcium chloride in absolute ethanol and titanium chloride (IV) in order to obtain a first solution;
b) dissolving ethylene oxide butadiene bi-block copolymer, PB-PEO, in ethanol, then adding water in order to obtain a second solution, heating said second solution at 45° C for 2 days and allowing said second solution to cool to ambient temperature in order to produce mono-dispersed micelles;
c) adding the first solution, drop by drop, to the second solution obtained in the step b) in order to obtain a mixture;
d) stirring the mixture obtained in the step c) for one hour before the deposition of said initial RNM.

8. Method for manufacturing a thin film of ordered silicon nanopatterns (4,5) according to claim 7, of which the ethylene oxide butadiene bi-block copolymer, PB-PEO, is either PB₁₁₂PEO₂₂₇, or PB₆₄₀PEO₉₈₉.

9. Method for manufacturing a thin film of ordered silicon nanopatterns (4,5) according to one of claims 7 or 8, wherein the bi-block copolymer, PB₁₁₂PEO₂₂₇ is chosen, and the initial RNM (1) is exposed to several successive cycles of the fluorinated plasma so as to obtain a homogeneous network of straight nanowires (4) of a diameter of about 20 nm.

10. Method for manufacturing a thin film of ordered silicon nanopatterns (4,5) according to claim 9, wherein the network of nanowires (4) is thermally or chemically oxidised, in order to decrease the diameter of said nanowires.

11. Method for manufacturing a thin film of ordered silicon nanopatterns (4,5) according to claim 9, wherein the network of nanowires (4) is covered by a deposition of organic and inorganic materials, so as to provide said nanowires with new properties.

12. Nanoperforated layer obtained by the method according to one of claims 1 to 7, used as a growth matrix for the production in particular of hybrid materials.

13. Silicon nanowires obtained by the method according to one of claims 9 to 11, used in a polymer matrix so as to obtain thin hybrid layers, conductive polymers and luminescent polymers.

14. Use of a network of ordered silicon nanopatterns obtained according to one of claims 9 or 10, in optical and/or photonic applications, for lighting, photovoltaic and LED.

15. Use of a network of ordered silicon nanowires obtained according to one of claims 9 to 10, in chemical and/or biological sensors.
